# EUROPEAN PATENT APPLICATION

(11) **EP 4 535 554 A1**
(43) Date of publication of application: **09.04.2025**
(21) Application number: 22943754.6
(22) Date of filing: 26.05.2022
(51) Int. Cl.: H01P 5/02

(54) **DC BLOCK STRUCTURE**

(71) Applicant: NIPPON TELEGRAPH AND TELEPHONE CORPORATION, Chiyoda-ku, Tokyo 100-8116 (JP)
(72) Inventor: WAKITA, Hitoshi, Musashino-shi, Tokyo 180-8585 (JP); NAGATANI, Munehiko, Musashino-shi, Tokyo 180-8585 (JP); JO, Teruo, Musashino-shi, Tokyo 180-8585 (JP); TAKEYA, Tsutomu, Musashino-shi, Tokyo 180-8585 (JP); TAKAHASHI, Hiroyuki, Musashino-shi, Tokyo 180-8585 (JP)
(74) Representative: Samson & Partner Patentanwälte mbB
(86) International application number: PCT/JP2022/021538
(87) International publication number: WO 2023/228352

(57) **Abstract**

A DC block structure includes a dielectric (1), transmission lines (2a, 2b) having characteristic impedance of 50 Ω and formed on a surface of the dielectric (1), transmission lines (3a, 3b) formed on the surface of the dielectric (1) so as to be connected with the transmission lines (2a, 2b) and designed so that characteristic impedance is higher than the characteristic impedance of the transmission lines (2a, 2b), and a capacitor (4) mounted on the transmission lines (3a, 3b) so as to connect the transmission line (3a) and the transmission line (3b) in series.

## Description

### Technical Field

The present invention relates to a DC block structure using a surface mount capacitor.

### Background Art

In recent years, an amount of data transmitted on a network has been increasing, and a method of improving a data transmission rate to cope with the increase has been researched and developed. A tendency to require high speed is similarly applied to an optical communication system, and broadband is also required for each device constituting a transceiver of the optical communication system.

A DC block is inserted between a plurality of devices connected in a cascade, and has a function of cutting a DC voltage component superimposed on a signal and transmitting only an AC signal component to the next stage. This function enables each device to be driven with an appropriate bias. In recent years, in optical communication, each device is required to have a very broadband characteristic from a DC vicinity to a vicinity region of 150 GHz. The DC block inserted between these devices is also required to have broadband.

As the broadband DC block, a silicon capacitor capable of forming an nF order capacitance on a thin film by applying a semiconductor CMOS process has attracted attention. Conventionally, in a frequency region of 100 GHz or less, a multi-layered chip capacitor (MLCC) which is relatively inexpensive and easily available has been used as the DC block.

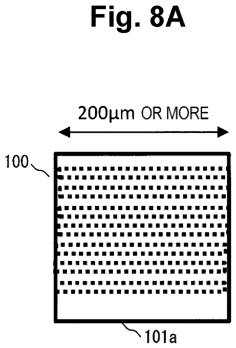

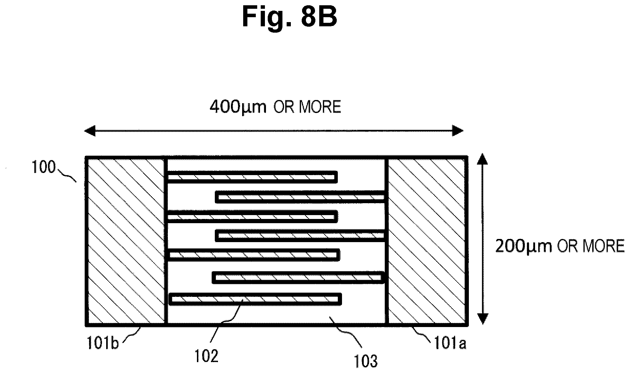

Fig. 8A is a front view of an MLCC, and Fig. 8B is a sectional view of the MLCC. An MLCC 100 includes two electrodes 101a and 101b, and has a structure in which an electrode layer 102 and a high dielectric 103 made of ceramics are alternately stacked. However, the MLCC has a problem that parasitic capacitances are likely to occur in the electrodes 101a and 101b, and it is difficult to use the MLCC in a region of 100 GHz or more due to characteristic deterioration.

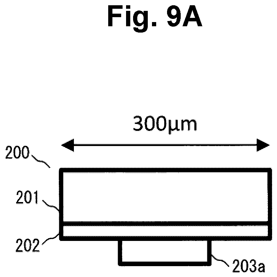

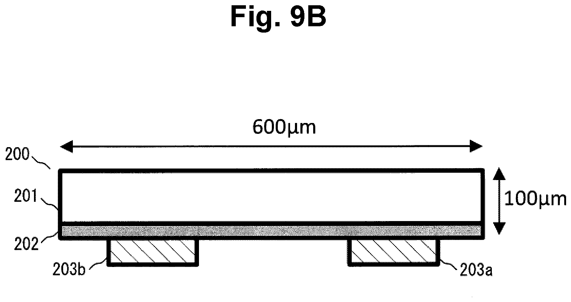

Fig. 9A is a front view of a silicon capacitor, and Fig. 9B is a sectional view of the silicon capacitor. A silicon capacitor 200 has a structure in which a thin film capacitor 202 is formed on a silicon substrate 201. Further, bumps 203a and 203b are formed so as to be connected with an electrode of the thin film capacitor 202. Since the silicon capacitor is formed with the thin film in capacitance, there is an advantage that the silicon capacitor is close to a structure of a transmission line and characteristic deterioration hardly occurs even in a high frequency range. However, the silicon capacitor has a problem that when a characteristic is further extended to the vicinity of 150 GHz, characteristic deterioration occurs in the vicinity of 125 GHz in a conventional mounting structure, and desired performance cannot be obtained.

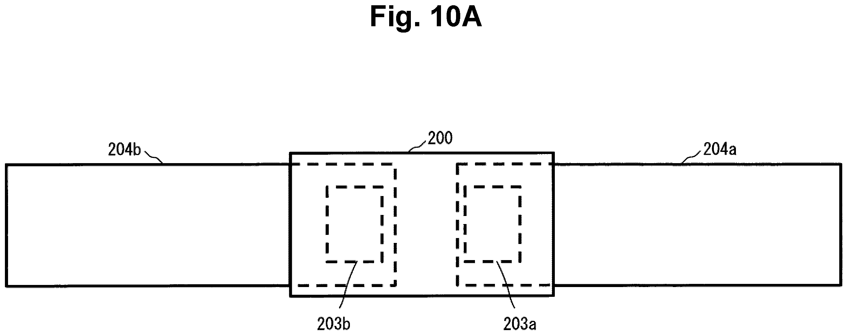

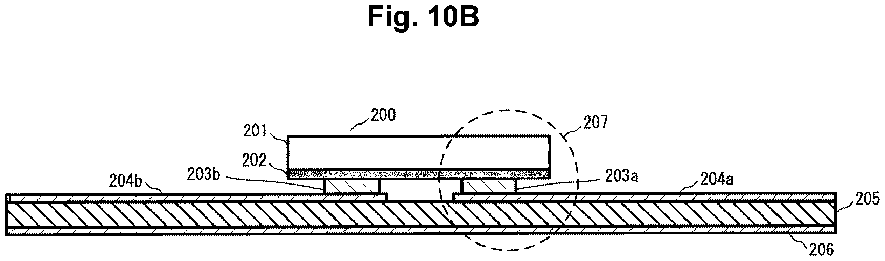

Fig. 10A shows a plan view of a conventional DC block structure using a silicon capacitor, and Fig. 10B shows a sectional view of the DC block structure. In the conventional DC block structure, the silicon capacitor 200 is inserted between a transmission line 204a and a transmission line 204b. The transmission lines 204a and 204b are formed on a surface of a dielectric 205. A ground conductor 206 is formed on a back surface of the dielectric 205. The silicon capacitor 200 is connected with the transmission lines 204a and 204b via the bumps 203a and 203b (see Non Patent Literature 1).

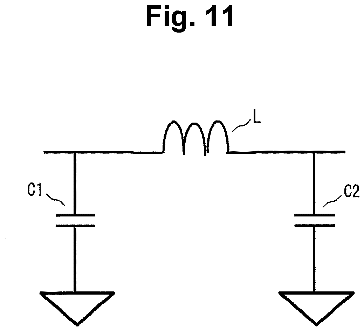

The inventors have found that in a case of the conventional DC block structure, there is a problem that a roll-off characteristic in which an insertion loss increases at a frequency of 150 GHz or less occurs. An equivalent circuit of a portion of the bump 203a indicated by a broken line 207 in Fig. 10B is as shown in Fig. 11. In Fig. 11, L represents an inductive component, C1 represents a capacitive component generated on the silicon capacitor 200 side, and C2 represents a capacitive component generated on the transmission line 204a side. The reason why the roll-off characteristic is generated at the frequency of 150 GHz or less is that portions of the bumps 203a and 203b act as low-pass filters in this manner.

### Citation List

### Non Patent Literature

Non Patent Literature 1: C. Bunel, et al., "Ultra thin low ESL and ultra wide broadband silicon capacitors", proceedings of 2016 International Conference on Electronics Packaging (ICEP), 2016

### Summary of Invention

### Technical Problem

The present invention has been made to solve the above problems, and an object thereof is to provide a broadband DC block structure having an improved frequency characteristic as compared with a conventional DC block structure.

### Solution to Problem

A DC block structure according to the present invention includes: a dielectric; a first transmission line formed on a surface of the dielectric; a second transmission line formed on the surface of the dielectric and designed so that characteristic impedance is the same as characteristic impedance of the first transmission line; a third transmission line formed on the surface of the dielectric so as to be connected with the first transmission line and designed so that characteristic impedance is higher than the characteristic impedance of the first and second transmission lines; a fourth transmission line formed on the surface of the dielectric so as to be connected with the second transmission line and designed so that characteristic impedance is higher than the characteristic impedance of the first and second transmission lines; and a capacitor mounted on the third and fourth transmission lines so as to connect the third transmission line and the fourth transmission line in series.

### Advantageous Effects of Invention

According to the present invention, by providing the third and fourth transmission lines, a frequency characteristic of the DC block structure can have a peaking characteristic. Therefore, it is possible to reduce a roll-off characteristic caused by connection portions between the capacitor and the transmission lines and improve the frequency characteristic of the DC block structure.

### Brief Description of Drawings

Fig. 1 is a perspective view of a DC block structure according to a first embodiment of the present invention.
Fig. 2A is a plan view of the DC block structure according to the first embodiment of the present invention.
Fig. 2B is a sectional view of the DC block structure according to the first embodiment of the present invention.
Fig. 3A is a plan view of a DC block structure according to a second embodiment of the present invention.
Fig. 3B is a sectional view of the DC block structure according to the second embodiment of the present invention.
Fig. 4 is a diagram illustrating simulation results of frequency characteristics of a conventional DC block structure and the DC block structure according to the second embodiment of the present invention.
Fig. 5A is a plan view of a DC block structure according to a third embodiment of the present invention.
Fig. 5B is a sectional view of the DC block structure according to the third embodiment of the present invention.
Fig. 6 is a perspective view of a DC block structure according to a fourth embodiment of the present invention.
Fig. 7 is a perspective view illustrating another example of the DC block structure according to the fourth embodiment of the present invention.
Fig. 8A is a front view of an MLCC.
Fig. 8B is a sectional view of the MLCC.
Fig. 9A is a front view of a silicon capacitor.
Fig. 9B is a sectional view of the silicon capacitor.
Fig. 10A is a plan view of a conventional DC block structure.
Fig. 10B is a sectional view of the conventional DC block structure.
Fig. 11 is an equivalent circuit diagram of the conventional DC block structure.

### Description of Embodiments

### [First Embodiment]

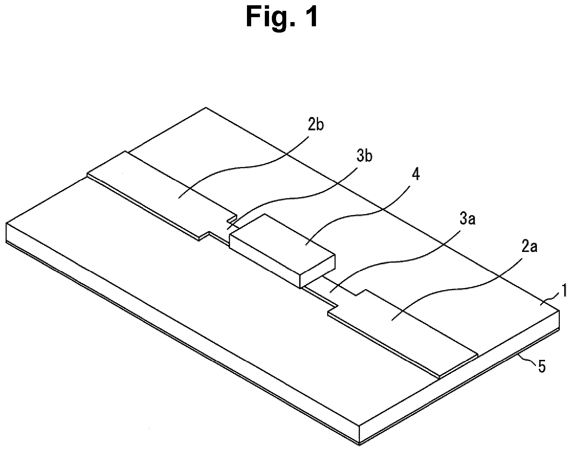

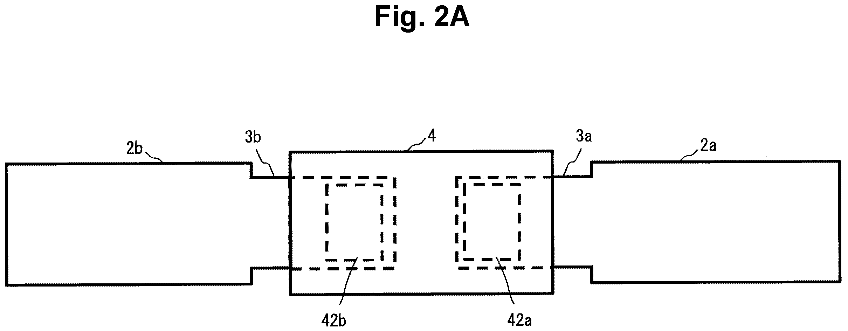

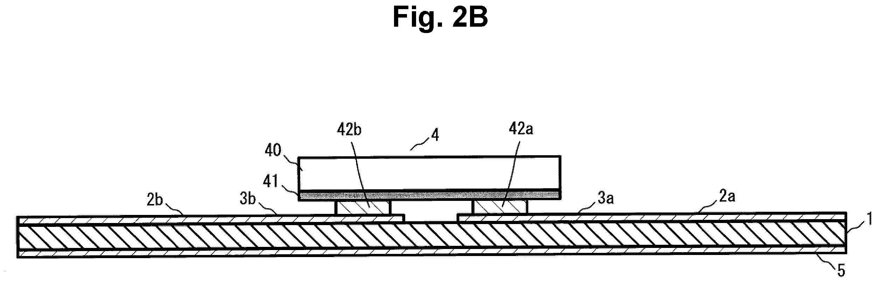

Hereinafter, embodiments of the present invention will be described with reference to the drawings. Fig. 1 is a perspective view of a DC block structure according to a first embodiment of the present invention, Fig. 2A is a plan view of the DC block structure, and Fig. 2B is a sectional view of the DC block structure. The DC block structure of the present embodiment includes a dielectric 1, transmission lines 2a and 2b having characteristic impedance of 50 Ω formed on a surface of the dielectric 1, a transmission line 3a formed on the surface of the dielectric 1 so as to be connected with the transmission line 2a and designed so that characteristic impedance is higher than the characteristic impedance of the transmission lines 2a and 2b, a transmission line 3b formed on the surface of the dielectric 1 so as to be connected with the transmission line 2b and designed so that characteristic impedance is higher than the characteristic impedance of the transmission lines 2a and 2b, a capacitor 4 mounted on the transmission lines 3a and 3b so as to connect the transmission lines 3a and 3b in series, and a ground conductor 5 formed on a back surface of the dielectric 1.

The characteristic impedance of the transmission line 3b is the same as the characteristic impedance of the transmission line 3a. Similar to a conventional DC block structure, the capacitor 4 is a silicon capacitor. The capacitor 4 has a structure in which a thin film capacitor 41 is formed on a silicon substrate 40. Further, bumps 42a and 42b are formed so as to be connected with an electrode of the thin film capacitor 41. The one bump 42a of the capacitor 4 is electrically connected with the transmission line 3a, and the other bump 42b is electrically connected with the transmission line 3b. In this way, the capacitor 4 is flip-chip mounted on the transmission lines 3a and 3b, and the transmission line 3a and the transmission line 3b are connected in series via the capacitor 4.

Also in the present embodiment, portions of the bumps 42a and 42b of the capacitor 4 function as low-pass filters, but it is possible to impart a peaking characteristic to a frequency characteristic by inductivity of the transmission lines 3a and 3b. As a result, in the present embodiment, a roll-off characteristic due to the function of the low-pass filters can be reduced, and the frequency characteristic of the DC block structure can be improved.

### [Second Embodiment]

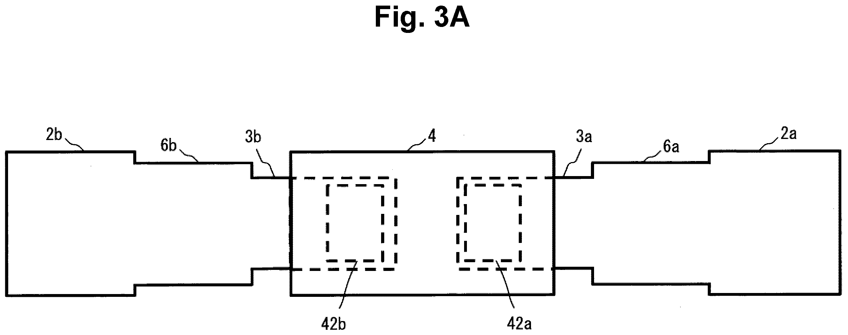

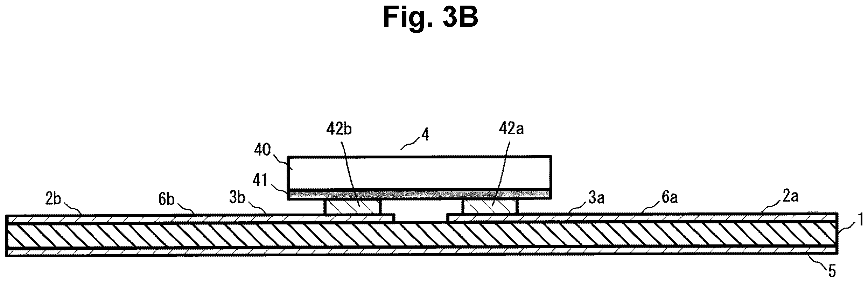

Next, a second example of the present invention will be described. Fig. 3A is a plan view of a DC block structure according to a second embodiment of the present invention, and Fig. 3B is a sectional view of the DC block structure. The same components as those of the first embodiment are denoted by the same reference numerals. The DC block structure of the present embodiment includes the dielectric 1, the transmission lines 2a, 2b, 3a, and 3b, the capacitor 4, the ground conductor 5, a transmission line 6a formed on the surface of the dielectric 1 so as to be inserted between the transmission line 2a and the transmission line 3a and designed so that characteristic impedance has a value between the characteristic impedance of the transmission line 2a and the characteristic impedance of the transmission line 3a, and a transmission line 6b formed on the surface of the dielectric 1 so as to be inserted between the transmission line 2b and the transmission line 3b and designed so that characteristic impedance has a value between the characteristic impedance of the transmission line 2b and the characteristic impedance of the transmission line 3b.

The characteristic impedance of the transmission line 6b is the same as the characteristic impedance of the transmission line 6a. In the present embodiment, by connecting the transmission line 2a and the transmission line 3a via the transmission line 6a and connecting the transmission line 2b and the transmission line 3b via the transmission line 6b, a plurality of peaking frequencies can be generated in a frequency characteristic of the DC block structure, and the frequency characteristic can be made flat.

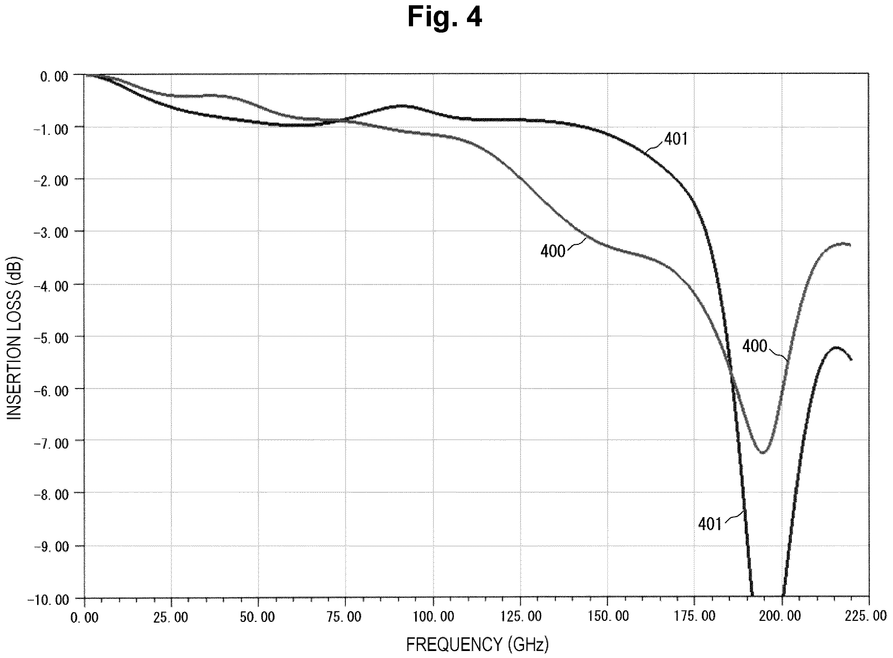

Fig. 4 is a diagram illustrating simulation results of frequency characteristics of the conventional DC block structure and the DC block structure of the present embodiment. In Fig. 4, reference numeral 400 denotes the frequency characteristic of the conventional DC block structure, and reference numeral 401 denotes the frequency characteristic of the DC block structure of the present embodiment. According to the present embodiment, it can be seen that roll-off around 150 GHz which has occurred in the conventional DC block structure is greatly improved.

### [Third Embodiment]

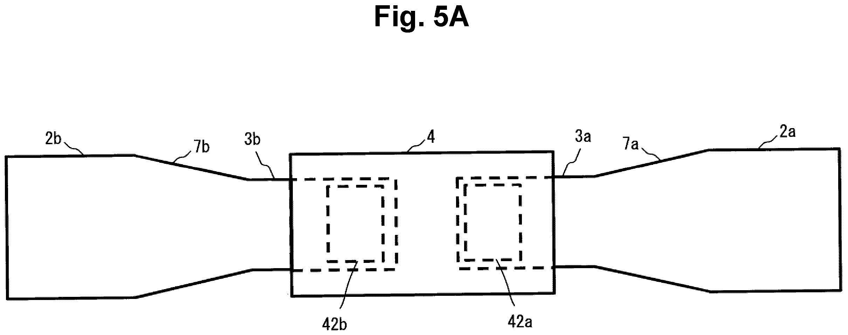

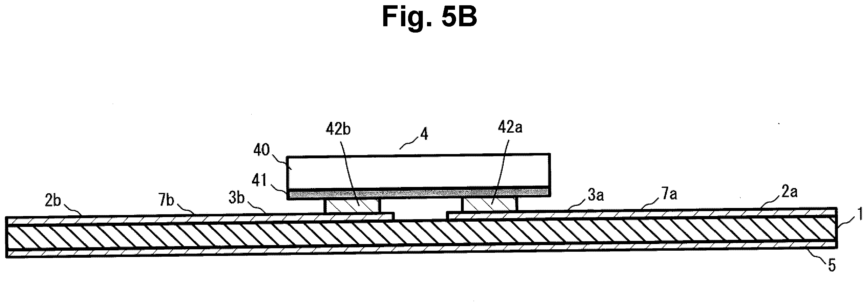

Next, a third embodiment of the present invention will be described. Fig. 5A is a plan view of a DC block structure according to a third embodiment of the present invention, and Fig. 5B is a sectional view of the DC block structure. The same components as those of the first embodiment are denoted by the same reference numerals. The DC block structure of the present embodiment includes the dielectric 1, the transmission lines 2a, 2b, 3a, and 3b, the capacitor 4, the ground conductor 5, a transmission line 7a formed on the surface of the dielectric 1 so as to be inserted between the transmission line 2a and the transmission line 3a and designed so that characteristic impedance has a value between the characteristic impedance of the transmission line 2a and the characteristic impedance of the transmission line 3a, and a transmission line 7b formed on the surface of the dielectric 1 so as to be inserted between the transmission line 2b and the transmission line 3b and designed so that characteristic impedance has a value between the characteristic impedance of the transmission line 2b and the characteristic impedance of the transmission line 3b.

The transmission line 7a is a transmission line having a tapered shape in plan view in which a width gradually changes from a width of the transmission line 2a to a width of the transmission line 3a. Similarly, the transmission line 7b is a transmission line having a tapered shape in plan view in which a width gradually changes from a width of the transmission line 2b to a width of the transmission line 3b. The characteristic impedance of the transmission line 7b is the same as the characteristic impedance of the transmission line 7a.

In the present embodiment, by connecting the transmission line 2a and the transmission line 3a via the transmission line 7a and connecting the transmission line 2b and the transmission line 3b via the transmission line 7b, a plurality of peaking frequencies can be generated in a frequency characteristic of the DC block structure, and the frequency characteristic can be made flat.

### [Fourth Embodiment]

In the first to third embodiments, a case where the transmission lines 2a, 2b, 3a, 3b, 6a, 6b, 7a, and 7b are microstrip lines has been described. However, the transmission lines 2a, 2b, 3a, 3b, 6a, 6b, 7a, and 7b may be coplanar lines or grounded coplanar lines.

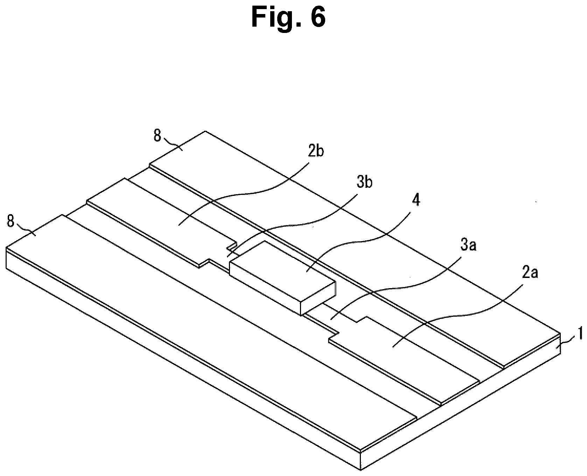

Fig. 6 is a perspective view illustrating an example in which the transmission lines 2a, 2b, 3a, and 3b in the first embodiment are coplanar lines. Ground conductors 8 are formed at positions on both outer sides of the transmission lines 2a, 2b, 3a, and 3b on a dielectric 1 along a propagation direction of a signal propagating through the transmission lines 2a, 2b, 3a, and 3b. With a configuration as illustrated in Fig. 6, a DC block structure can be formed even when a ground conductor cannot be formed on the back surface of the dielectric 1, and a degree of freedom in design can be increased.

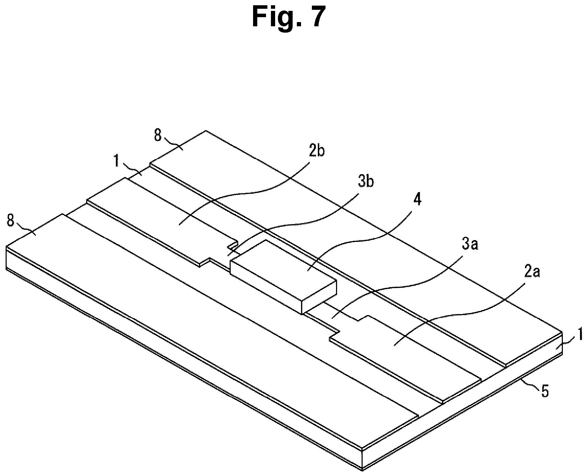

Fig. 7 is a perspective view illustrating an example in which the transmission lines 2a, 2b, 3a, and 3b in the first embodiment are grounded coplanar lines. In the example of Fig. 7, the ground conductors 8 are formed at positions on both outer sides of the transmission lines 2a, 2b, 3a, and 3b on the dielectric 1 along the propagation direction of the signal propagating through the transmission lines 2a, 2b, 3a, and 3b, and the ground conductor 5 is formed on the back surface of the dielectric 1.

In the examples of Figs. 6 and 7, the configuration in which the coplanar lines or the grounded coplanar lines are applied to the first embodiment is illustrated, but it is needless to say that the configuration may be applied to the second and third embodiments. That is, similarly to Fig. 6, when the ground conductors 8 are formed on both outer sides of the transmission lines 2a, 2b, 3a, 3b, 6a, and 6b or on both outer sides of the transmission lines 2a, 2b, 3a, 3b, 7a, and 7b, a coplanar line configuration is obtained. Further, when the ground conductor 5 is formed on the back surface of the dielectric 1 as in Fig. 7, a grounded coplanar line configuration is obtained.

In the coplanar line or the grounded coplanar line, characteristic impedance of each transmission line can be designed to a desired value by adjusting an interval between the transmission lines 2a, 2b, 3a, 3b, 6a, 6b, 7a, and 7b and the ground conductor 8.

### [Fifth Embodiment]

In the first to fourth embodiments, the bumps 42a and 42b of the capacitor 4 may be solder bumps formed by a back end process or stud bumps formed using a wire bonder.

In a case of the stud bump, a height of the bump can be changed depending on mounting conditions and a bump material. A combination of the height design of the bump and the line design makes it possible to expect further improvement in a frequency characteristic of the DC block structure.

### Industrial Applicability

The present invention can be applied to a technique of mounting a capacitor on a high frequency line.

### Reference Signs List

1 Dielectric
2a, 2b, 3a, 3b, 6a, 6b, 7a, 7b Transmission line
4 Capacitor
5, 8 Ground conductor
40 Silicon substrate
41 Thin film capacitor
42a, 42b Bump

## Claims

1. A DC block structure comprising:
a dielectric;
a first transmission line formed on a surface of the dielectric;
a second transmission line formed on the surface of the dielectric and designed so that characteristic impedance is same as characteristic impedance of the first transmission line;
a third transmission line formed on the surface of the dielectric so as to be connected with the first transmission line and designed so that characteristic impedance is higher than the characteristic impedance of the first and second transmission lines;
a fourth transmission line formed on the surface of the dielectric so as to be connected with the second transmission line and designed so that characteristic impedance is higher than the characteristic impedance of the first and second transmission lines; and
a capacitor mounted on the third and fourth transmission lines so as to connect the third transmission line and the fourth transmission line in series.

2. The DC block structure according to claim 1, further comprising:
a fifth transmission line formed on the surface of the dielectric so as to be inserted between the first transmission line and the third transmission line and designed so that characteristic impedance has a value between the characteristic impedance of the first transmission line and the characteristic impedance of the third transmission line; and
a sixth transmission line formed on the surface of the dielectric so as to be inserted between the second transmission line and the fourth transmission line and designed so that characteristic impedance has a value between the characteristic impedance of the second transmission line and the characteristic impedance of the fourth transmission line.

3. The DC block structure according to claim 2, wherein
the fifth transmission line is a transmission line having a tapered shape in plan view in which a width gradually changes from a width of the first transmission line to a width of the third transmission line, and
the sixth transmission line is a transmission line having a tapered shape in plan view in which a width gradually changes from a width of the second transmission line to a width of the fourth transmission line.

4. The DC block structure according to any one of claims 1 to 3, further comprising
a ground conductor formed on a back surface of the dielectric.

5. The DC block structure according to claim 1, further comprising
first ground conductors formed at positions on both outer sides of the first, second, third, and fourth transmission lines on the dielectric.

6. The DC block structure according to claim 2, further comprising
first ground conductors formed at positions on both outer sides of the first, second, third, fourth, fifth, and sixth transmission lines on the dielectric.

7. The DC block structure according to claim 5 or 6, further comprising
a second ground conductor formed on a back surface of the dielectric.

8. The DC block structure according to any one of claims 1 to 3, wherein
the capacitor is a silicon capacitor in which a thin film capacitor is formed on a silicon substrate, and is mounted on the third and fourth transmission lines via bumps.
